# EUROPÄISCHE PATENTANMELDUNG

(11) **EP 2 320 457 A2**
(43) Veröffentlichungstag der Anmeldung: **11.05.2011**
(21) Anmeldenummer: 11154345.0
(22) Anmeldetag: 22.03.2007
(51) Int. Cl.: H01L 23/373, H01L 23/367

(54) **Trägerkörper für Bauelemente oder Schaltungen**

(30) Priorität: 23.03.2006 DE 102006013873
(62) Teilanmeldung aus: 07727202.9
(71) Anmelder: CeramTec GmbH, 73207 Plochingen (DE)
(72) Erfinder: Kluge, Dr. Claus Peter, 95195, Röslau (DE)
(74) Vertreter: Uppena, Franz

(57) **Zusammenfassung**

Die Erfindung betrifft einen Trägerkörper (1, 2) für elektrische oder elektronische Bauelemente (6a, 6b, 6c, 6d) oder Schaltungen, wobei der Trägerkörper (1, 2) elektrisch nicht oder nahezu nicht leitend ist und der Trägerkörper (1, 2) einstückig mit Wärme ab- oder zuführenden Kühlelementen (7) versehen ist.
Zur Vereinfachung des Trägerkörpers (1) bei gleichzeitiger extrem verbesserter Wärmeableitung wird erfindungsgemäß vorgeschlagen, dass der Trägerkörper (1, 2) eine Platine ist, der Trägerkörper (1, 2) und das Kühlelement (7) aus einer Keramik oder aus einem Kompositmaterial besteht und das Kompositmaterial elektrisch nicht oder nahezu nicht leitende Matrixmaterialien mit Wärme leitenden Zuschlagstoffen enthält und auf der Oberfläche des Trägerkörpers (1, 2) versinterte Metallisierungsbereiche (41) aufgebracht sind.

## Beschreibung

Die Erfindung betrifft einen Trägerkörper für elektrische oder elektronische Bauelemente oder Schaltungen, wobei der Trägerkörper elektrisch nicht oder nahezu nicht leitend ist.

Nach dem Stand der Technik werden zur Wärmeableitung von Modulen der Leistungselektronik planare Strukturen aufgebaut, welche die aus einer Wärmequelle (aktive oder passive elektrische Komponente) diffundierende Hitze über zahlreiche Zwischenschichten (Lote, Leitpasten, Klebstoffe, Metallisierungen) in einen elektrisch nicht leitenden, gleichmäßig geformten, einfachen geometrischen Körper (Scheibe, rechteckiges Substrat) abführen. Die Geometrie der einzelnen Komponenten ist zwar einfach, der gesamte Schichtaufbau ist kompliziert und bedingt eine konsekutive Anwendung verschiedenster fehlerbehafteter Verfahren wie Kleben, Pressen, Schrauben und eingeschränkt auch das Löten. Jede Grenzschicht dieses Stapelaufbaus stellt eine Barriere für den Wärmeübergang dar und verringert entweder die Zuverlässigkeit und/oder Lebensdauer des Moduls (Oxidation, Durchbrennen, Alterung) oder begrenzt dessen Leistung.

Organische und keramische Schaltungsträger (Trägerkörper) mit geringer oder nicht ausreichender Wärmeleitfähigkeit müssen durch zusätzliche Maßnahmen, wie elektrisch isolierende Zwischenschichten, an einen metallischen Kühlkörper dauerhaft formschlüssig angebaut werden. Bei steigenden Wärmebelastungen müssen teilweise die Wärmequellen von der Platine ausgelagert werden und im klassischen Sinne auf einen metallischen Kühlkörper montiert und mit dem Schaltungsträger elektrisch verbunden werden.

Der Aufbau aus mehreren unterschiedlichen Materialien ist komplex und ein Kompromiss, wenn man die Langzeitzuverlässigkeit betrachtet. Eine Steigerung der Leistungsdichte ist nur im geringen Umfang möglich.

Die Wärmeleitfähigkeit kann nur bedingt benutzt werden, da es sich um einen planparallelen Aufbau handelt.

Ein direkter Verbund von elektrisch leitfähigem Kühlkörper und einer Wärmequelle ist ebenso nicht möglich.

Zur Vereinfachung des Trägerkörpers bei gleichzeitiger extrem verbesserter Wärmeableitung wird erfindungsgemäß vorgeschlagen, dass der Trägerkörper einstückig mit Wärme ab- oder zuführenden Kühlelementen ausgebildet ist.

In einer erfindungsgemäßen Ausgestaltung ist der Trägerkörper eine Platine. Auf dem Trägerkörper sind dann die Leiterbahnen aufgebracht. Leiterbahnen der Platine können beispielsweise über einen thermischen Prozess mit dem Trägerkörper innig verbunden sein oder metallische Leiterbahnen können aufgeklebt sein oder es können Leitkleber Anwendung finden. Es können auch Kombinationen unterschiedlicher Leiterbahntypen zum Einsatz kommen.

Bevorzugt haben die Komponenten einen direkten Wärmeabfluss in den Trägerkörper oder auch in die Kühlelemente. Die Komponenten können beispielsweise direkt oder über eine oder mehrere Schichten mit dem Trägerkörper verbunden sein.

Die Begriffe Bauelemente und Komponenten beschreiben dieselben Gegenstände.

Bevorzugt sind die Kühlelemente Bohrungen, Kanäle, Rippen und/oder Ausnehmungen, die von einem Kühlmedium beaufschlagbar sind.

Das Heiz- oder Kühlmedium kann ein Gas, wie z. B. Luft oder eine Flüssigkeit, wie z. B. Wasser oder Öl sein.

In bevorzugter Ausgestaltung besteht der Trägerkörper aus mindestens einer keramischen Komponente oder einem Verbund von unterschiedlichen Keramiken. Die keramischen Komponenten können im kristallographischen Sinne einkristallin oder polykristallin oder in Kombinationen hiervon vorkommen.

Keramische Komponenten oder Keramiken können beispielsweise Aluminiumoxid, technisches Aluminiumoxid, Zirkonoxid, unterschiedlich dotierte Zirkonoxide, Aluminiumnitrid, Siliziumnitrid, Siliziumoxid, Glaskeramik, LTCC (Low Temperature Cofired Ceramics) Keramiken, Siliziumcarbid, Bornitrid, Boroxid sein.

Von besonderer technischer Bedeutung sind technisches 96%iges Aluminiumoxid mit Wärmeleitfähigkeiten von ca. 24 W/mK, sowie technisches >99%iges Aluminiumoxid mit ca. 28 W/mK, technische oder reine Aluminiumnitride mit beispielsweise ca. 180 W/mK, mit Zirkonoxid verstärkte Aluminiumoxide mit ca. 24 W/mK, sowie Glaskeramiken mit ca. 2 W/mK.

Hohe Wärmeleitfähigkeiten sind in Anwendungen wie Powerelektronik, High Power LED, träge Hochlastsicherungen, Powerwiderstände von besonderer technischer Bedeutung. Niedrige Wärmeleitfähigkeiten sind bei flinken Hochlastwiderständen von besonderer technischer Bedeutung, sowie bei Anwendungen, bei denen eine möglichst gleichmäßige Temperaturverteilung über eine Fläche (den Trägerkörper) gewährleistet sein muss. Hier wären beispielsweise thermoanalytische Messaufbauten zu nennen.

Sinnvoller Weise sind die Kühlelemente mit dem Trägerkörper versintert, wodurch die Herstellung vereinfacht und in vielen Fällen damit auch die Dauerhaltbarkeit des gesamten Aufbaues verbessert ist.

In spezieller Ausgestaltung besteht der Trägerkörper aus einem Kompositmaterial, und das Kompositmaterial enthält elektrisch nicht oder nahezu nicht leitende Matrixmaterialien mit Wärme leitenden Zuschlagsstoffen.

Als Matrixmaterialien werden bevorzugt Harze, Polymere oder Silikone verwendet.

Die Kompositmaterialien sind in bevorzugter Ausgestaltung aus Polymeren oder Silikonen, gemischt mit keramischen Komponenten, bestehende Mehrstoffsysteme, wie zum Beispiel:
a) Polymere mit Al₂O₃
b) Polymere mit AlN
c) Silikone mit Al₂O₃/AlN
d) Silikone und Polymere mit ZrO₂/Y₂O₃

Der Trägerkörper und/oder das Kühlelement kann auch ein Komposit aus Metall und/oder Keramik oder ein Verbund von Keramik und Metall sein.

Der Trägerkörper und/oder das Kühlelement sind in einer Ausführungsform mehrschichtig aufgebaut.

Sinnvoller Weise sind die Bauelemente mit dem Trägerkörper elektrisch leitend und/oder Wärme leitend verbunden. Bauelemente können beispielsweise elektrische oder elektronische oder aktive oder passive oder geometrische Körper oder beliebige Kombinationen davon sein.

In Weiterbildung der Erfindung ist mit dem Trägerkörper oder Kühlelement mindestens eine Montagemöglichkeit verbunden.

Über die Montagemöglichkeit kann der Trägerkörper mit weiteren Trägerkörpern mit oder ohne elektrische oder elektronische Bauelemente oder Schaltungen verbunden sein. Die Befestigung kann über Verschrauben, Nieten, Klemmen, Kleben, Crimpen, Schweißen, Löten oder weitere Befestigungsmöglichkeiten erfolgt.

Der Trägerkörper kann die Funktion des Kühlkörpers übernehmen und umgekehrt.

Die Kühlelemente sind bevorzugt in gleichen oder beliebigen Größen und/oder in gleichen oder verschiedenen räumlichen Ausrichtungen mit dem Trägerkörper einstückig verbunden.

Die Kühlelemente können beliebige Oberflächenstrukturierungen tragen oder aufweisen, die den Effekt der Oberflächenveränderung nach sich ziehen.

Vorteilhafterweise sind eine oder mehrere Oberflächenstrukturierungen oder deren Kombinationen auf einem oder mehreren Kühlelementen angeordnet, zum Beispiel Aufrauungen, Riefen, Wellen, Durchbrüche in der Oberfläche oder dendritische oder verästelnde Strukturen.

Bevorzugt sind die Oberflächenstrukturierungen z.B. planare oder unebene oder raue Oberflächen von Trägerkörpern oder Kühlelementen, die mit ebenfalls unebenen oder planaren oder rauen Oberflächen von zu montierenden Komponenten insbesondere formschlüssig und/oder dauerhaft und/oder temporär oder als Kombination hiervon verbunden sind. Die Verbindungsart kann beispielsweise Löten oder Kleben sein.

In spezieller Ausführungsform haben der Trägerkörper oder die Kühlelemente vollflächigen oder teilflächigen Formschluss mit Bauelementen. Der Verbund kann beispielsweise dauerhaft oder temporär oder als Kombination hiervon vorliegen. Bauelemente können beispielsweise elektrische oder elektronische oder aktive oder passive oder geometrische Körper oder beliebige Kombinationen davon sein.

In einer Ausgestaltung sind der Trägerkörper oder die Kühlelemente flächig oder mit Aussparungen oder mit Erhöhungen versehen, wobei diese bevorzugt einstückig mit dem Trägerkörper oder den Kühlelementen ausgebildet sind.

Weiterhin kann bevorzugt der Trägerkörper mit Metallschichten >5pm verbunden sein, die beispielsweise über DCB Verfahren (Direct Copper Bonding) oder AMB Verfahren (Active Metall Brazing) aufgebracht werden.

Der erfindungsgemäße Aufbau mit Komponenten liegt beispielsweise im Ruhezustand bei Raumtemperatur vor. Während des Betriebes können nun an den Komponenten durch den Betrieb derselben in kürzester Zeit lokale Temperaturmaxima entstehen. Es kommt zu einem so genannten Thermoschock der Umgebung der Komponente. Der erfindungsgemäße Aufbau kann diesen Zustand ohne Eigenschädigung überstehen. Finden diese Zustände im Wechsel statt, ein so genannter Thermowechsel, kommt es bei herkömmlichen Aufbauten mit beispielsweise geklebten Leiterbahnen, nach relativ wenigen Zyklen beispielsweise zu Ablöseerscheinungen von Leiterbahnen vom Trägerkörper. Der erfindungsgemäße Aufbau zeigt eine deutlich verbesserte Thermowechselbeständigkeit wie herkömmliche Aufbauten.

In Weiterbildung der Erfindung sind auf dem Trägerkörper gleiche oder unterschiedliche Bauelemente in gleicher oder unterschiedlicher räumlicher Ausrichtung befestigt. Die Ausrichtung kann beispielsweise durch unterschiedliche Lotmengen oder Aussparungen oder Erhöhungen oder beliebige Kombinationen von Ausrichtungsmöglichkeiten erfolgen. Bei z. B. LED's kann dadurch deren Ausrichtung und damit der Lichtschein auf einfache Art und Weise ausgerichtet werden.

Der erfindungsgemäße Trägerkörper oder das Kühlelement lassen sich vorteilhaft als Montagekörper verwenden.

In einer Ausgestaltung der Erfindung sind mit dem Trägerkörper sensorische Komponenten verbunden. Sensorische Komponenten können beispielsweise Signale abgeben aus denen Größen wie Druck, Temperatur, Gewicht, etc. abgeleitet werden können.

In einer Ausgestaltung der Erfindung werden aus der teilweisen oder gesamten Verformung des Trägerkörpers sensorische Signale abgeleitet.

Bevorzugt ist der Trägerkörper teilweise mit metallischen Bereichen versehen. Diese Bereiche können die Ober- und Unterseite des Trägerkörpers beispielsweise elektrisch miteinander verbinden.

Bevorzugt baut der Trägerkörper nahezu kein elektrochemisches Potential gegenüber anderen Materialien aufbaut. Damit kann beispielsweise bei entsprechender Koppelung die Korrosion des Trägerkörpers oder der Umgebung signifikant vermindert werden.

In erfinderischer Ausgestaltung wird der Trägerkörper als Wärmequelle verwendet, in dem die entstehende Wärme über den Trägerkörper oder das Kühlelement an das zu temperierende Medium abgegeben wird.

Bevorzugt weist der Trägerkörper durch zugeführte Wärme oder Kälte, welche auf den Trägerkörper übertragen wird oder über die Kühlelemente zugeführt wird, eine gezielte Temperaturverteilung auf. Beispielsweise können somit Temperaturdifferenzen der Umgebung gezielt ausgeglichen werden.

Bevorzugt sind auf dem Trägerkörper Stoffe aufgebracht, welche Bondprozesse ermöglichen. Beispielhaft kann hier ein Metallisierungsaufbau W-Ni-Au (Wolfram-Nickel-Gold) verwendet werden, um Golddrahtbonding zu ermöglichen. Die Stoffe können aus einem oder mehreren Materialien bestehen, die gemischt oder aus mindestens einer Schicht auf den Trägerkörper aufgebracht sind. Die Stoffe können beispielsweise Materialien wie Gold oder Schichten aus mehreren Materialien wie Kupfer, Nickel und Gold oder aus Mischungen von mindestens zwei unterschiedlichen Materialien, wie beispielsweise Metallen und/oder Zuschlagstoffen, sowie Schichten aus gleichen oder unterschiedlichen Metallen oder Zuschlagstoffen bestehen.

In Weiterbildung der Erfindung sind mit dem Trägerkörper eine oder mehrere Licht emittierende Stoffe oder einer oder mehrere Licht emittierende Komponenten oder Kombinationen hiervon verbunden. Beispielsweise kann dieses ein Halbleiter oder ein Gehäuse mit einem Halbleiter sein wie es für LED Beleuchtungen eingesetzt wird.

Bevorzugt sind mit dem Trägerkörper innig oder durch mechanischen Formschluss vollflächig oder teilflächig verbundenen Metalle oder Metallschichten verbunden, die eine gleiche oder unterschiedliche Wärmeleitfähigkeit wie der Trägerkörper besitzen. Metalle oder Metallschichten können beispielsweise Wolfram, Silber, Gold, Kupfer, Platin, Palladium, Nickel in reiner oder technischer Qualität sein oder Mischungen von mindestens zwei unterschiedlichen Metallen sein. Metalle oder Metallschichten können auch beispielsweise mit Haft vermittelnden oder anderen Zuschlagstoffen wie Gläsern oder polymeren Materialien vermischt sein. Metalle oder Metallschichten können beispielsweise auch Reaktionslote, Weichlote oder Hartlote sein.

Es ist besonders hervorzuheben, dass im Falle von punktförmigen Wärmequellen die Wärme sehr schnell über die gesamte Oberfläche des Trägerkörpers gespreizt, d.h. verteilt werden muss. Somit kann ein Trägerkörper, mit vergleichsweise geringer Wärmeleitfähigkeit, die entstehende Wärme über das Metall auf seine Gesamtfläche verteilt bekommen. So kann die Wärme auf die Kühlelemente abgeleitet werden. Da der Trägerkörper elektrisch isolierend ist kann das Metall gleichzeitig die Funktion elektrische Leitfähigkeit und thermische Leitfähigkeit erfüllen.

In erfindungsgemäßer Ausgestaltung können die Metalle oder die Metallschichten auf den Trägerkörpern verschiedene Funktionen haben. So können sie die Funktion der elektrischen Leitfähigkeit und/oder der thermischen Leitfähigkeit oder die Funktion einer Farbveränderung der Oberfläche oder thermische Spreizung oder ein Haftvermittler zu dritten Materialien, wie beispielsweise Loten, Klebern, sowie beliebige Kombinationen der Funktionen gleicher oder verschiedener Metallbereiche haben.

Der Vorteil liegt in der angepassten Stromtragfähigkeit der Metallbereiche. Daher müssen diese zum Beispiel nicht zwingend die gleichen Höhen oder Dicken haben.

Folglich sind die Metalle bevorzugt vollflächig oder teilflächig in gleichen oder unterschiedlichen Dicken (Höhen) mit dem Trägerkörper in gleichen oder unterschiedlichen Metallbereichen verbunden.

In einer anderen erfindungsgemäßen Ausgestaltung sind gleiche oder unterschiedliche Metalle einschichtig oder mehrschichtig mit gleichen oder unterschiedlichen Dicken (Höhen) mit dem Trägerkörper vollflächig oder teilflächig verbunden.

In einer weiteren Ausgestaltung trägt der Trägerkörper die Eigenfärbung des oder der verwendeten Materialen vollflächig oder teilflächig oder sind Teilbereiche des Trägerkörpers abweichend von der Eigenfärbung verfärbt. Die Farbgebung kann durch unterschiedliche Arten und Kombination dieser Arten entstehen:

Der Trägerkörper, auf Basis eines technischen Aluminiumoxides, kann beispielsweise während des Herstellungsprozesses desselben mit farbgebenden Zusatzstoffen versehen werden, so dass als Resultat einer thermischen Behandlung das Bulk Material vollständig und mechanisch untrennbar durchgefärbt ist.

Der Trägerkörper, beispielsweise auf Basis eines technischen Zirkonoxides, kann nach dem Herstellungsprozess desselben beispielsweise oberflächlich mit farbgebenden Zusatzstoffen versehen werden, so dass als Resultat einer thermischen Behandlung die Oberfläche des Bulk Materials vollständig durchgefärbt ist. Je nach Eindringtiefe der resultierenden Verfärbung kann das Bulk Material auch seine Eigenfärbung im inneren behalten. Der Gradient der Verfärbung kann unterschiedlichste Charakteristiken annehmen.

Der Trägerkörper, beispielsweise auf Basis eines technischen Aluminiumnitrides, kann mit farbgebenden Schichten versehen werden, so dass als Resultat das Bulk Material des Trägerkörpers nicht verfärbt wird und die farbliche Veränderung lediglich durch eine oder mehrere mechanisch trennbaren Schichten erzeugt wird. Farbgebende Schichten können beispielsweise Lacke, Lasuren, Klebefolien, Metalle etc. sein.

In einer anderen Ausgestaltung ist der Trägerkörpers mit mindestens einem weiteren geometrisch gleichen oder ungleichen Trägerkörper über geeignete Verbindungsmaterialien zu einer Art dreidimensionalem Array verbunden.

Verbindungsmaterialien können einschichtiger oder mehrschichtiger Natur sein. Verbindungsmaterialien können gleichartig oder unterschiedlich sein oder auch in Kombination mit einschichtigem oder mehrschichtigem Aufbau verwendet werden. Beispielhaft sind Verbindungsmaterialien wie Kleber, Metallisierungen, Metalle, Metalle die beispielhaft mit Verfahren wie DCB (Direct Copper Bonding oder AMB (Active Metal Brazing) mit dem Trägerkörper verbunden worden sind, zu nennen. Es können auch beispielsweise Lote, Reaktionslote, beidseitige Klebefolien, etc. verwendet werden.

In einer Ausführungsform ist der Trägerkörpers mit einem oder mehreren Licht emittierenden Stoffen oder einer oder mehrerer Licht emittierender Komponenten sowie Kombinationen hiervon verbunden und ist gleichzeitig mit genormten oder ungenormten elektrischen Verbindern versehen ist. Es können auch Kombinationen von gleichen oder unterschiedlichen elektrischen Verbindern eingesetzt werden. Es wird bevorzugt eine dem elektrischen Verbinder angemessene mechanische Verbindung zu dem Trägerkörper verwendet. Elektrische Verbinder können beispielsweise Lampensockel E27, E14, GU-Serie, G-Serie, U-Serie, R-Serie, Stecksockel, Bayonettsockel, Klemmverbinder, Schraubverbinder, Steckverbinder, etc. sein. Mechanische Verbindungen oder Kombinationen von mechanischen Verbindungen können beispielsweise Kleben, Löten, Quetschen, Nieten, Klemmen, etc. sein.

In weiterer Ausgestaltung ist mindestens ein Trägerkörper mit mindestens einem weiteren geometrischen Körper über geeignete Verbindungsmaterialien zu einer Art dreidimensionalem Aufbau verbunden. Verbindungsmaterialien können einschichtiger oder mehrschichtiger Natur sein. Verbindungsmaterialien können gleichartig oder unterschiedlich sein oder auch in Kombination mit einschichtigem oder mehrschichtigem Aufbau verwendet werden. Mindestens ein oder mehrere gleiche oder ungleiche Trägerkörper können an beliebigen Stellen in gleichen oder unterschiedlichen Orientierungen angebracht sein. Beispielhaft wären Verbindungsmaterialien, wie Kleber, Metallisierungen, Metalle, Metalle die beispielhaft mit Verfahren wie DCB (Direct Copper Bonding oder AMB (Active Metal Brazing) mit dem Trägerkörper verbunden worden sind, Lote, Reaktionslote, beidseitige Klebefolien, etc. zu nennen. Beispielhaft können geometrische Körper Platten sein, auf denen sich in unterschiedlichen Bereichen mindestens eine oder mehrere gleiche oder unterschiedlichen Trägerkörper befinden.

Der Trägerkörper kann beispielsweise Bestandteil eines Kunststoffgehäuses sein.

In einer anderen Ausgestaltung sind mindestens ein und/oder unterschiedliche oder gleiche Trägerkörper beliebig oder gleichsinnig orientiert in ein Matrixmaterial eingebettet. Das Einbetten kann beispielsweise durch Injection moulding oder Druckguss geschehen. Die Einbettmassen selber sind beliebig und den jeweiligen Zielfunktionen entsprechend auszuwählen. Kunststoffe eignen sich vorzüglich.

Erfindungsgemäß kann bei einem Trägerkörper durch Modifikation der Größe oder der Einfärbung oder der Größe oder Verteilung der metallisierten Bereiche oder der Geometrie oder der Ausgestaltung der Kühlelemente oder der Anzahl der Kühlelemente oder Kombinationen von diesen eine Veränderung des Wärmetransportes erreicht werden. Verändert man beispielsweise das Design der Kühlelemente kann sich bei konstantem Wärmeeintrag, über die Abgabe oder Aufnahme von Wärmeenergie, die Absoluttemperatur im eingeschwungenen Zustand bzw. im Gleichgewichtszustand verändern. Dies kann beispielsweise auch durch gezieltes Hinzufügen oder Entfernen oder Vergrößern oder Verkleinern von Kühlelementen stattfinden. Die Veränderung kann beispielsweise auch durch Veränderung der Farbe stattfinden. So ist die Abstrahlcharakteristik eines schwarzen Körpers anders als bei einem weißen Körper.

In einer bevorzugten Ausgestaltung stehen die Oberflächen des Trägerkörpers zu den Oberflächen des Kühlelements in einem Verhältnis von 1 zu x, wobei x >= 1,1 ist. Von besonderer technischer Bedeutung ist x >= 1,8, weil dadurch die transportierbare Wärmemenge größer ist.

Bevorzugt sind auf der Oberfläche des Trägerkörpers versinterte Metallisierungs bereiche aufgebracht.

in erfindungsgemäßer Ausgestaltung bestehen die Metallisierungsbereiche aus Wolfram und sind chemisch vernickelt. Die Metallisierungsbereiche sind in einer Ausgestaltung kreisförmig ausgebildet.

In spezieller Ausgestaltung ist der Trägerkörper mit elektrischen Leiterbahnen versehen, über die elektrische Spannungen bis in den kV Bereich hinein transportierbar sind, ohne dass ein elektrischer Spannungsabfluss über das Bulk Material des Trägerkörpers erfolgt. Von besonderem technischen Interesse sind elektrische Spannungsbereiche von 80 Volt bis 600 Volt, sowie Spannungen >> 2 k-Volt (2.000 Volt).

In bevorzugter Ausführungsform weist der Trägerkörper keine oder eine geringe Abschirmwirkung gegenüber elektrischen oder magnetischen oder elektromagnetischen Feldern oder Kombinationen von diesen auf und somit können diese Felder den Trägerkörper auch durchdringen.

In einer Ausgestaltung ist der Trägerkörper gezielt vollflächig oder teilflächig mit Materialien versehen, deren Funktion es ist Bereiche zu schaffen, in denen eine unterschiedliche Abschirmwirkung gegenüber elektrischen oder magnetischen oder elektromagnetischen Feldern oder Kombinationen hiervon, im Vergleich zu der Abschirmwirkung des Materials des Trägerkörpers, auftritt.

Bevorzugt sind durch gezieltes Aufbringen von geeigneten Materialien, wie beispielsweise Metallen, auf den Trägerkörper Bereiche angeordnet, die aufgrund ihrer Geometrie über induktive oder kapazitive Effekte oder Kombinationen von diesen in der Lage sind elektrische oder magnetische oder elektromagnetische Signale zu empfangen oder zu senden. Signale im weitesten Sinne dienen der drahtlosen Übertragung von Energie. Die Energie kann beispielsweise durch Modulation zusätzliche Informationen mit übertragen.

In einer erfindungsgemäßen Ausgestaltung ist der Trägerkörper mit der Funktionalität einer intelligenten Selbstidentifizierung ausgestattet. Selbstidentifizierung kann beispielsweise ein Schriftzug oder eine Markierung oder ein Magnetstreifen mit entsprechender Information oder eine RFID Einheit oder Kombinationen dieser sein.

In einem Ausführungsbeispiel besteht der Trägerkörper aus technischem Aluminiumoxid mit einem minimalen Aluminiumoxidgehalt von 89%. Die Metallisierungsbereiche sind dazu geeignet, beispielsweise Bauteile auflöten zu können und damit einen innigen Verbund herzustellen. Der Verbund mit beispielsweise einer handelsüblichen LED kann über eine Lotverbindung hergestellt werden. Die Lotverbindung hat mindestens die Funktionen der mechanischen Verbindung von LED und Trägerkörper. Zusätzlich ermöglichen die Metallisierungsbereiche die elektrische Kontaktierung der LED sowie den thermischen Kontakt.

Am Beispiel eine Aufbaues eines Trägerkörpers mit aufgedruckten und versinterten Metallisierungsbereichen (auch Leiterbahnquerschnitten) mit aufgelöteter Punktwärmequelle, beispielsweise einer LED, kann der technisch notwendige elektrische Leiterbahnquerschnitt signifikant größer gewählt werden als erforderlich, da gleichzeitig zur elektrischen Leitung über die Metallisierungsbereiche und Leiterbahnquerschnitte auch die Wärmespreizung auf eine größere Oberfläche des Trägerkörpers stattfindet und damit auf die Kühlelemente verteilt wird. Gegenüber einem elektrisch sinnvollen und ausreichendem kleineren Metallisierungsbereich und Leiterbahnquerschnitt kann über vergrößerte Metallisierungsbereiche und Leiterbahnquerschnitte eine größere Wärmemenge in kürzerer Zeit über die Fläche des Trägerkörpers und von dort aus auf die Kühlelemente verteilt werden.

Der Trägerkörper oder das Kühlelement, nachfolgend auch Körper genannt, kann bevorzugt aus mindestens einer keramischen Komponente oder einem Verbund von unterschiedlichen Keramiken bestehen. Beispielsweise sind technisches Aluminiumoxid 80 - 99,9 %, Aluminiumoxid, Berylliumoxid, Zirkonoxid, stabilisiertes Zirkonoxid, Aluminiumnitrid, zirkonverstärktes Aluminiumoxid, Glaskeramik oder Keramiken die durch Mischungen von mindestens zwei verschiedenen Keramiken oder Zusätzen entstanden sind, zu benennen. Einkristalline Keramiken können beispielsweise Saphir sein.

Der Körper kann auch aus einem Kompositmaterial bestehen. Es können Matrixmaterialien, z. B. Harze, Polymere oder Silikone mit Zuschlagstoffen verwendet werden. Die Zuschlagstoffe bewirken eine Veränderung der Wärmeleitfähigkeit der Matrixmaterialien. Mehrstoffsysteme können bevorzugt sein Polymere mit Al₂O₃, Polymere mit AIN, Silikone mit Al₂O₃/AlN.

Der Körper kann starr oder flexibel oder eine Kombination von starr-flexibel sein.

Der Körper kann ein Komposit Metall - Keramik oder ein Verbund von Körper und Metall sein.

Der Körper kann mehrschichtig aufgebaut sein mit innen liegenden Leiterbahnen und elektrischen Bauteilen wie Widerstände, Spulen, Kondensatoren, etc., wobei auch elektrisch leitfähige Bereiche zwischen den Lagen möglich sind.

Der Körper kann auch als Ersatz für einen elektrisch leitfähigen Kühlkörper eingesetzt werden, hier insbesondere, wenn die Umgebung korrosiv wirkt.

Der Körper kann gleichzeitig auch Montagegehäuse sein.

Die Verwendung des erfindungsgemäßen Trägerkörpers hat folgende Vorteile:
➢ Reduzierung der Komponentenvielfalt
➢ Erweitern der Funktionsvielfalt
➢ Eigensicherung gegen thermische Überlast
➢ Langzeitzuverlässigkeit
➢ Vermeidung TCE missmatch durch Verwendung unterschiedlichster Materialien
➢ Leistungssteigerung durch verbesserte Wärmeabfuhr
➢ Schwierigkeit, hohe Verlustwärmen direkt abzuführen, wurde überwunden
➢ Grundprinzip lässt sich auf mannigfaltige Anwendungen übertragen
➢ Eine "von selbst" systemimmanente thermische Balance
➢ Umweg Wärmequelle in einem separaten Gehäuse zu montieren, welches wiederum auf Körper montiert werden kann, ist eliminiert

Wärmequellen können elektrische oder elektronische Bauteile sein, wie z. B. Heizelemente, Peltierelemente, Widerstände, aktive und passive Halbleiter.

Die Wärme kann bewusst als Funktion erzeugt werden oder als Nebenprodukt bei der Ausübung der Funktion anfallen.

Die Wärmequellen können auch während des Betriebes Änderungen in der Funktionsfähigkeit durch die eigene produzierte Wärme erfahren.

Die Wärmequellen können direkt mit dem Körper, z. B. mit einer Lötverbindung, verbunden werden.

### IGBT

Module werden je Fläche mit immer höheren Leistungen belegt und die dauerhafte Funktionsfähigkeit dieser Module kann nur durch Montage von Kühlkörpern gewährleistet werden.

Hier wird der erfindungsgemäße Trägerkörper zur thermischen Ableitung gewählt.

### LED (Light emitting diode)

Mit dem Stand der Technik ist es bisher nicht oder nur eingeschränkt möglich, höhere geforderte Leuchtdichten zu erreichen. Gründe sind das mit dem nach Stand der Technik verbundene schlechte thermische Management. Mit steigender Leuchtdichte steigt die Abwärme. Die Abwärme beeinflusst die Lebensdauer und die Farbkonstanz signifikant. Gleiches gilt auch für Anwendungen mit Laserdioden.

Erfindungsgemäß können die Halbleiter direkt auf eine Platine montiert werden oder zuvor eingehaust und dann als Bauteil auf die Platine gesetzt werden. Die auf der Platine angeordnete Schaltung wiederum wird erfindungsgemäß durch die Kühlelemente gekühlt oder der Halbleiter wird direkt mit einem zusätzlichen Kühlkörper versehen. Halbleiter können beispielsweise auch Solarzellen sein, da deren Leistungsabgabe mit steigender Temperatur sinkt. In diesem Fall würde der Halbleiter selber durch den Betrieb keine Abwärme produzieren die abgeführt werden muss, sondern hier wird der Halbleiter durch den IR-Anteil des Sonnenlichtes aufgewärmt.

### Steuerungen

Nach dem Stand der Technik werden z. B. im Automobil die Wärmequellen von der Schaltung separiert und elektrisch verbunden. Auch hier kommt der Aufbau mit Wärme leitfähigen Kühlkörpern zum Einsatz.

### Korrosion von Kühlkörpern

Unter bestimmten Anwendungsbedingungen kommt es bei elektrisch leitenden Kühlkörpern zur Oberflächenkorrosion. Die durch chemische Umwandlung entstehenden Oberflächenverbindungen verändern den Übergang zum Kühlmedium und können auch die Oberfläche, z. B. durch Lochfraß, verändern. Trägerkörper aus einer Keramik mit integrierten Kühlelementen beheben dieses Problem.

### Keramisches Heizelement

Verwendung zur thermischen Stabilisierung des Kühlkörpers selber, bzw. der direkten oder indirekten Umgebung.

### Peltieranwendung

Peltierelemente haben eine kalte und warme Seite. Je nach Anwendung ist der Aufbau immer in Kombination mit einem separaten Kühlkörper zu sehen. Hier kann das Peltierelement direkt auf den elektrisch isolierenden Kühlkörper aufgebracht werden.

Sensorik intern / oberflächlich wegen direkter Rückkopplung im eigenen System

Der Kühlkörper selber kann eingebrachte oder auf eine Oberfläche montierte/aufgebrachte Sensorik enthalten. Durch die direkte Ankopplung an das System sind selbst regulierende Schutzfunktionen der Wärmequellen möglich.

### Montage des Kühlkörpers

Montagepunkte, Pads, Kavitäten, Montagebolzen Aktive und passive Kühlung
- Bohrungen
- Lüfter
- Rippen in Kühlmedium anders als Luft

Der Stand der Technik erfordert bei der Montage von Bauteil und Kühlkörper oft auch eine Dritte Komponente, eine so genannte Wärmeleitfolie, welche gleichzeitig auch elektrisch isolierend sein muss. Damit der gewünschte Effekt der Wärmeabfuhr erzielt werden kann, müssen Kühlkörper und Bauteil ebene und planparallele Oberflächen ausweisen, damit ein 100%iger Formschluss gewährleistet ist. Kommt noch eine Wärmeleitfolie hinzu, muss auch diese eine ebene und planparallele Oberfläche ausweisen. Bei der Montage eines solchen Aufbaues wird oft eine Verschraubung gewählt. Kommt es nun bei der Montage oder während des Betriebes zu Verzügen im Aufbau, kann der thermische Kontakt partiell verloren gehen. Damit ist die Funktionalität und Lebensdauer des Aufbaues in Frage gestellt.

Erfindungsgemäß steht nun erstmalig die Möglichkeit einer Lötverbindung auf den elektrisch isolierenden Kühlkörpern, wobei die oben beschriebenen Nachteile der thermischen Ankoppelung während des Lötvorganges nicht entstehen.

### Mehrlagen Sandwichaufbau

Einfache mechanische Verbindungen des Kühlkörpers zur Montage der Einheit selber und zur Verbindung mit weiteren Kühlkörpern und/oder an Körper gebundene Funktionen.

### Selbstgekühlte Platine

Stand der Technik ist es, eine Platine mit unzureichendem thermischen Management mit einem elektrisch leitfähigen Kühlkörper zu versehen. Dabei sind der thermischen Anbindung insofern Grenzen gesetzt, als diese langzeitstabil sein muss. Limitierende Faktoren sind z. B. die zeitliche und geometrische Veränderung des elektrisch isolierenden Mediums.

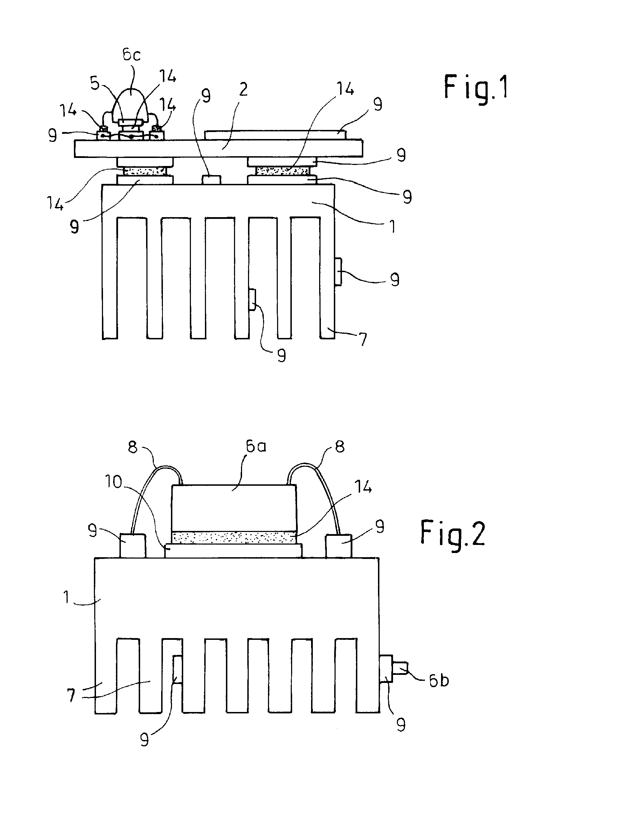

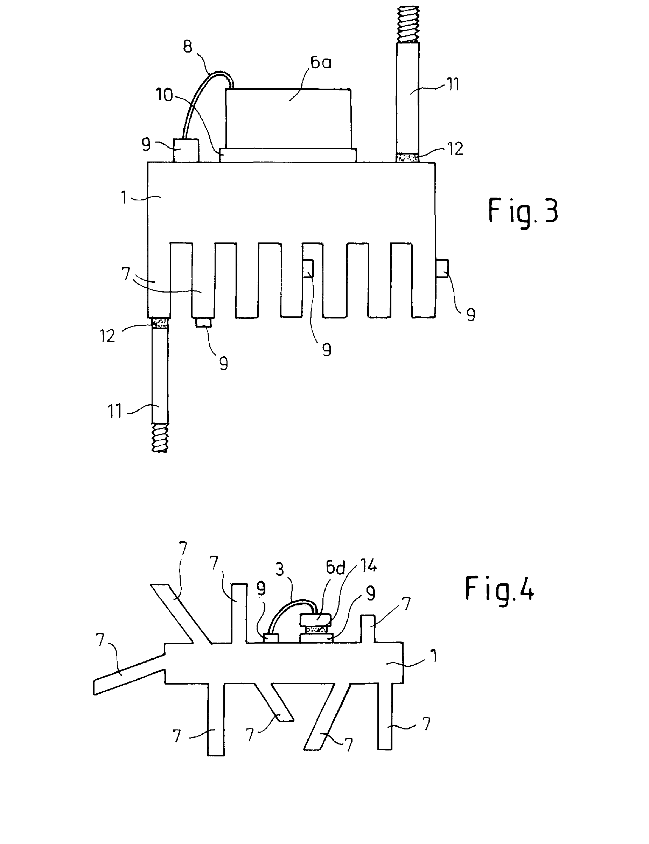

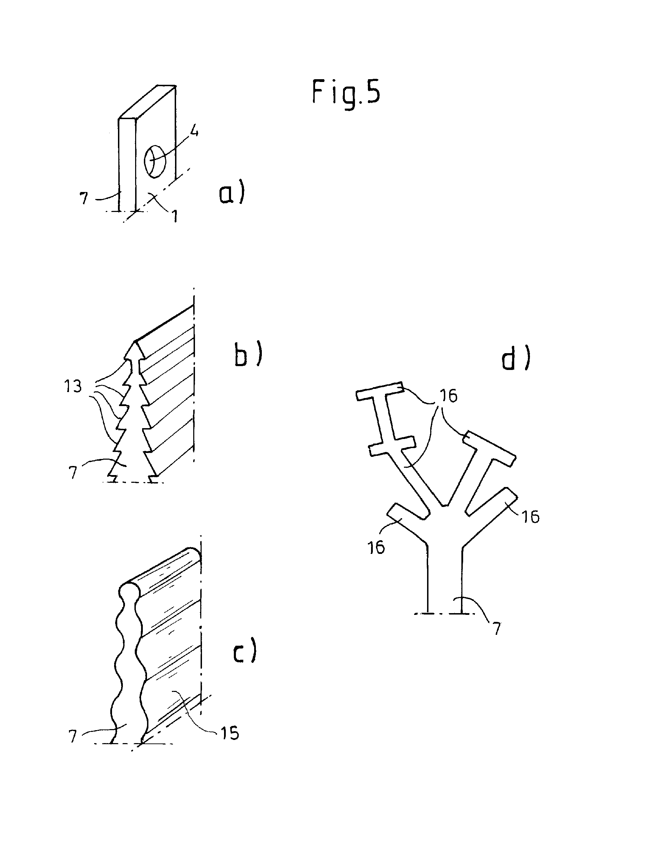

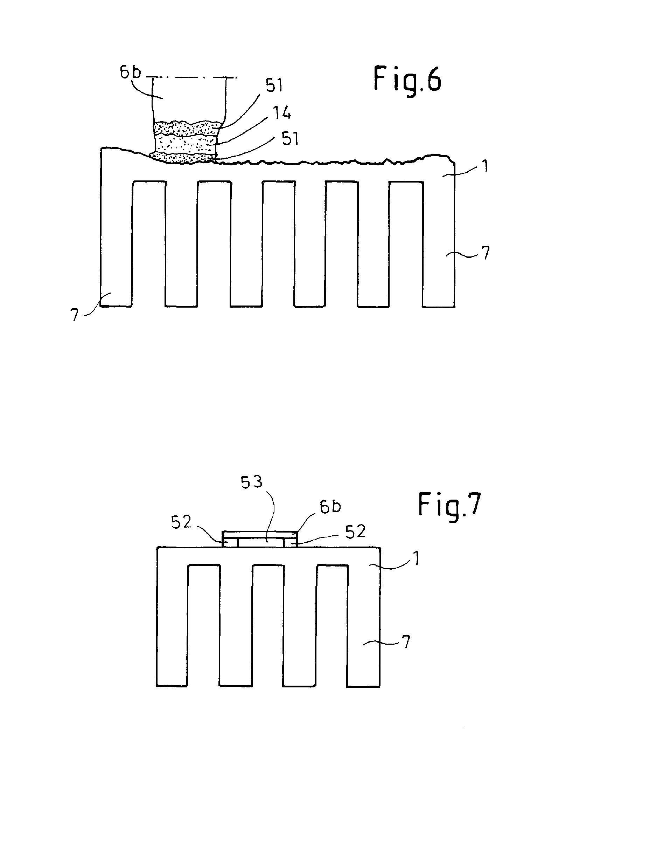

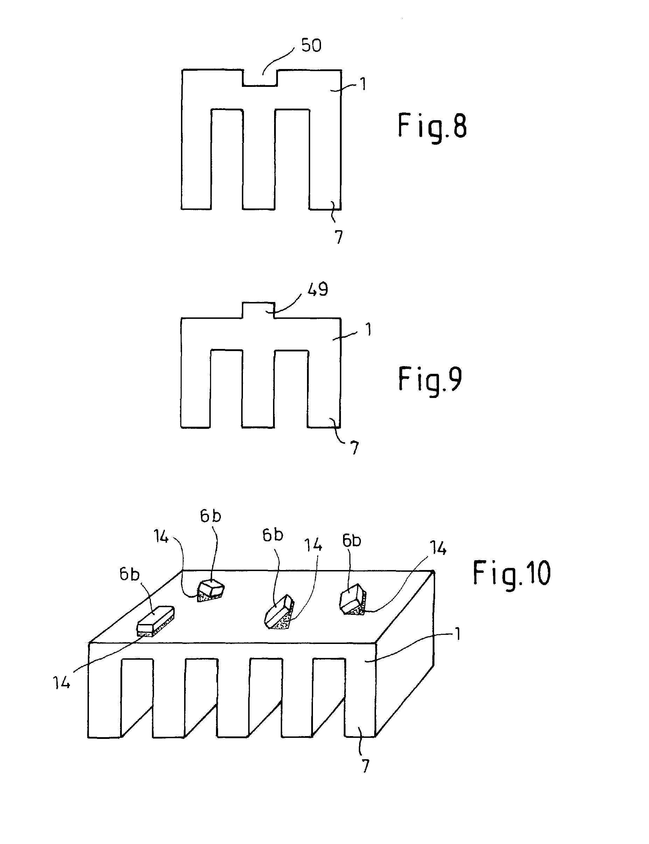

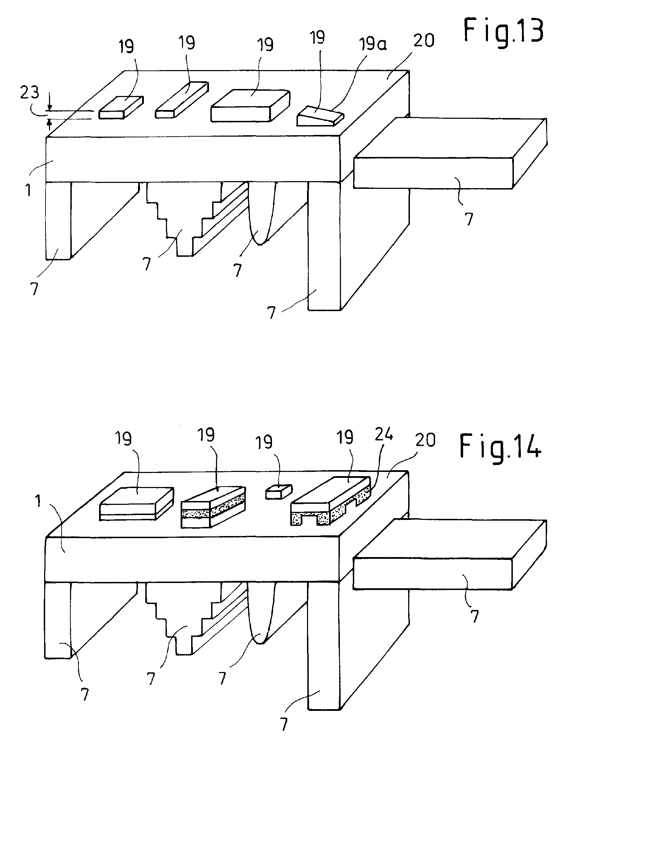

Die Figuren 1 bis 20 zeigen Ausführungsformen des erfindungsgemäßen Trägerkörpers 1.
Figur 1 zeigt beispielhaft einen Trägerkörper 1 aus einer Keramik mit einstückig als Rippen ausgebildeten Kühlelementen 7 aus Keramik. Auf dem Trägerkörper 1 befindet sich ein weiterer unabhängiger Trägerkörper 2. Die Trägerkörper 1 und 2 tragen jeweils metallhaltige d.h. elektrisch leitende Schichten 9. Die Verbindung von Trägerkörper 2 auf Trägerkörper 1 kann mittels einer Lotverbindung 14 dargestellt werden. Damit kann eine Entwärmung bzw. Abkühlung des Trägerkörpers 2 über den Trägerkörper 1 an die Kühlelemente 7 stattfinden. An Trägerkörper 2 kann eine LED 6c angebracht werden, indem man die Basisplatte 5 der LED 6c über eine Lotverbindung 14 mit der metallhaltigen Schicht 9 des Trägerkörpers 2 verbindet. Die Kühlelemente 7 sind durch versintern einstückig mit dem Trägerkörper 1 verbunden. Die Kühlelemente 7 selber können auch als Trägerkörper fungieren. Es ist auch die Kombination von mehr als zwei Trägerkörpern von Vorteil.
Figur 2 zeigt einen Trägerkörper 1 aus einer Keramik mit einstückig als Rippen ausgebildeten Kühlelementen 7 aus Keramik. Auf diesem Trägerkörper 1 befindet sich ein Chip 6a, der stellvertretend für eine beliebige Wärmequelle steht. Dieser Chip 6a ist über Leitungen 8 mit elektrisch leitenden Schichten 9 verbunden. Der Chip 6a kann direkt mit dem Trägerkörper 1 verbunden sein oder beispielsweise über eine lötfähige Metallschicht 10 auf diesem mit der Lotverbindung 14 verbunden werden. Mit dem Bezugszeichen 6b ist ein weiteres elektrisches oder elektronisches Bauelement bezeichnet, welches wie der Chip 6a eine Wärmequelle darstellt. Das Bauteil 6b ist am Kühlelement 7 auf einer elektrisch leitenden Schicht 9 angeordnet. Das Kühlelement 7 übernimmt daher hier auch die Funktion eines Trägerkörpers. Die Kühlelemente 7 sind durch versintern einstückig mit dem Trägerkörper 1 verbunden. Auch die anderen Kühlelemente 7 können als Trägerkörper fungieren.
Figur 3 zeigt beispielhaft die Möglichkeit, den Trägerkörper 1 und/oder die Kühlelemente 7 über eine Montagemöglichkeit, z.B. einer Verschraubung 11 mit weiteren Komponenten, zum Beispiel einem weiteren Trägerkörper oder einem übergeordneten Bauelement, über eine Klebemasse 12 oder ähnliche Befestigungsmöglichkeiten zu verbinden. Die Verschraubung 11 stellt somit eine Montagemöglichkeit dar. Ansonsten ist der Trägerkörper 1 mit dem von Figur 2 nahezu identisch.
Figur 4 zeigt beispielhaft die Möglichkeiten der Anordnung von gleichen oder unterschiedlich geformten Kühlelementen 7 am Trägerkörper 1. Die Kühlelemente 7 können bezüglich ihrer Orientierung zur Oberfläche des Trägerkörpers 1 beliebig, gleichartig oder in Kombinationen hiervon in alle Raumrichtungen zeigen. Hier ist ein Halbleiter 6d mit einer Lotschicht 14 über eine metallhaltige elektrisch leitende Schicht 9 mit dem Trägerkörper 1 verbunden. Der Halbleiter 6d ist außerdem mit einem Draht 3 mit der metallhaltigen Schicht 9 verbunden.
Die Figuren 5a - 5d zeigen unterschiedliche Möglichkeiten, wie Oberflächenmodifikationen aussehen können. Figur 5a zeigt eine Oberflächenmodifikation durch Einbringen von Kavitäten und Löchern 4 in die Kühlelemente 7.
Figur 5b zeigt eine Oberflächenmodifikation durch Einbringen von kantigen Riefen 13 und / oder gleichzeitigem Dickenverlauf des Kühlelementes 7.
Figur 5c zeigt eine Oberflächenmodifikation durch Einbringen von welligen Riefen 15 in die Kühlelemente 7.
Figur 5d zeigt eine Oberflächenmodifikation durch astartige Verzweigungen 16 im Kühlelement 7.
Figur 6 zeigt eine uneben geformte raue Oberfläche eines Trägerkörpers 1, die mit einem Bauteil 6 b verbunden ist. Bauteil 6 b und Trägerkörper 1 sind mit einer lötfähigen Metallisierungsschicht 51 versehen. Der vollständige Formschluss erfolgt über eine Lotverbindung 14.
Figur 7 zeigt einen Trägerkörper 1, auf dem ein Bauelement 6 b über eine partiell formschlüssige Verbindung 52 angeordnet ist. Zwischen der formschlüssigen Verbindung 52 sind Bereiche 53 ohne Formschluss angeordnet.
Figur 8 zeigt eine Aussparung 50 im Trägerkörper 1 und Figur 9 eine Erhöhung 49 auf einem Trägerkörper 1.
Figur 10 zeigt einen Trägerkörper 1 mit Kühlelementen 7. Auf dem Trägerkörper 1 sind Bauelemente 6 b über eine Lotverbindung 14 in verschiedener räumlicher Anordnung angeordnet. Zum Beispiel könnten die Bauelemente 6 b LED's sein, die in verschiedene Richtungen strahlen sollen.

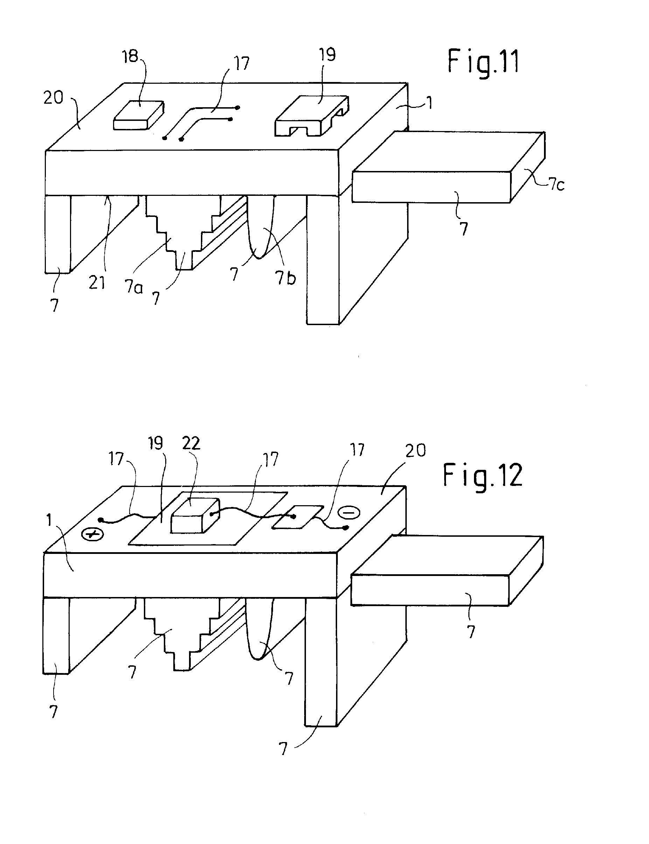

Figur 11 zeigt einen Trägerkörper 1 mit einstückig verbundenen Kühlelementen 7. Der Trägerkörper 1 und die Kühlelemente 7 bestehen aus einem keramischen Werkstoff und sind beide durch einen Sinterpozess einstückig miteinander verbunden, sie sind also ein einziges Bauteil. Ein Kühlelement 7 a ist im Querschnitt treppenförmig, ein anderes Kühlelement 7 b ist im Querschnitt zapfenförmig und ein anderes Kühlelement 7 c ist quaderförmig ausgebildet. Die Kühlelemente 7 a und 7 b sind auf der Unterseite 21 des Trägerkörpers 1 angeordnet. Ein Kühlelement 7 c ist seitlich am Trägerkörper 1 und Kühlelement 7 angeordnet. Auf der Oberseite 20 des Trägerkörpers 1 sind Leiterbahnen 17 angeordnet. Mit Unterseite 21 ist die zur Oberseite 20 abgewandte Seite des Trägerkörpers 1 bezeichnet. Auf der Oberseite 20 des Trägerkörpers 1 ist neben den Leiterbahnen 17, hier nur schematisch dargestellt, als ein Metall, Kupfer 18 mit dem DCB-Verfahren vollflächig aufgebracht. Zusätzlich ist auch ein Metall 19 teilflächig aufgebracht. Bevorzugt ist die Wärmeleitfähigkeit des Metalls 19 ungefähr gleich der Wärmeleitfähigkeit des Trägerkörpers 1 und/oder der Kühlelemente 7. Unter Wärmeleitfähigkeit wird das Verhältnis von Watt/mK verstanden. Natürlich kann die Wärmeleitfähigkeit des Metalls 19 auch ungleich der Wärmeleitfähigkeit des Trägerkörpers 1 und/oder der Kühlelemente 7 sein.
Figur 12 zeigt einen Trägerkörper 1 mit Kühlelementen 7, wie er auch in Figur 11 1 gezeigt ist. Auf der Oberseite 20 ist auf einem Metall 19 eine Wärmequelle 22 angeordnet. Angesteuert wird die Wärmequelle 22 über Leiterbahnen 17. Die Leiterbahnen 17 haben die Funktion der elektrischen Leitfähigkeit und das Metall 19 hat die Funktion der thermischen Spreizung und der elektrischen Leitfähigkeit.
Figur 13 zeigt einen Trägerkörper 1 mit Kühlelementen 7, wie er auch in den Figuren 11 und 12 gezeigt ist. Auf der Oberseite 20 des Trägerkörpers 1 sind Metalle 19 angeordnet, die sich in ihrer Dicke 23 d.h. Höhe unterscheiden. Metall 19 a weist einen Dickengradienten auf, d.h. die Dicke nimmt kontinuierlich von einer Seite zur anderen Seite stetig zu. Die Metalle 19 können vollflächig oder teilflächig mit dem Trägerkörper 1 verbunden sein.
Figur 14 zeigt einen Trägerkörper 1 mit Kühlelementen 7, wie er auch in den Figuren 11 bis 13 gezeigt ist. Auf der Oberseite 20 sind Metalle 19 mehrschichtig angeordnet. Es können sowohl mehrere Schichten eines einzigen Metalls als auch mehrere Schichten von unterschiedlichen Metallen aufgebracht sein. Einzelne Schichten können auch eine Struktur 24 aufweisen.
Figur 15 a zeigt einen Trägerkörper 1 mit Kühlelementen 7, wie in den Figuren 11 bis 13 gezeigt. Der Trägerkörper 1 kann durchgefärbt (siehe Bereich 48) sein oder es können auch nur einzelne Bereiche des Trägerkörpers 1 gefärbt sein.

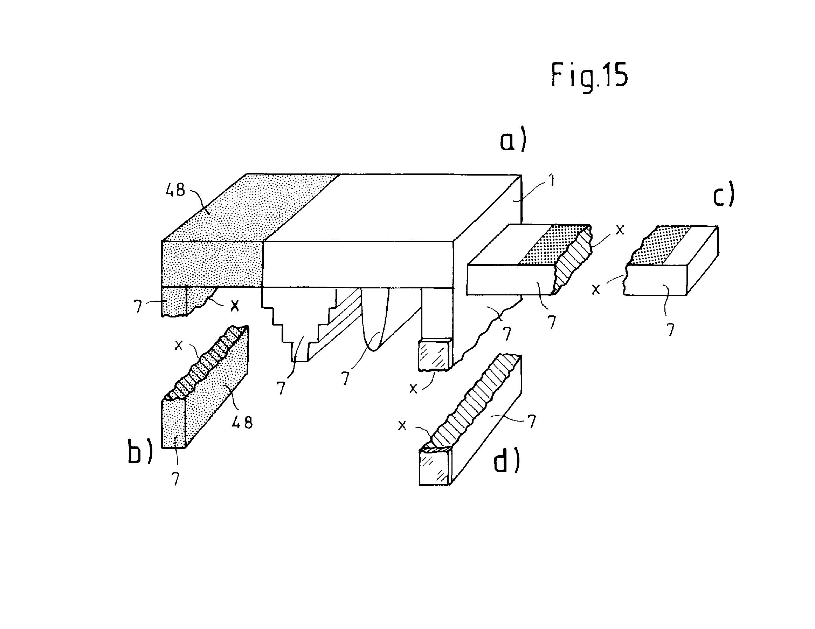

Figur 15 b zeigt einen Ausschnitt des Trägerkörpers 1 oder Kühlelements 7 entlang einer Bruchkante x. Es ist eine gleichmäßige Durchfärbung zu erkennen.
Figur 15 c zeigt eine Verfärbung, die als Gradient ausgeführt ist. Nach Herstellung des Trägerkörpers 1 mit den Kühlkörpern 7 wird ein farbgebender Zusatzstoff aufgebracht, der nach einer thermischen Behandlung das Bulkmaterial verfärbt.
Figur 15 d zeigt einen Ausschnitt aus dem Kühlkörper 7, bei dem das Bulkmaterial nicht verfärbt ist. Dafür ist eine Oberflächenbeschichtung aufgebracht, zum Beispiel ein Lack. Mit dem Bezugszeichen x ist die Bruchkante in allen Figuren gekennzeichnet.

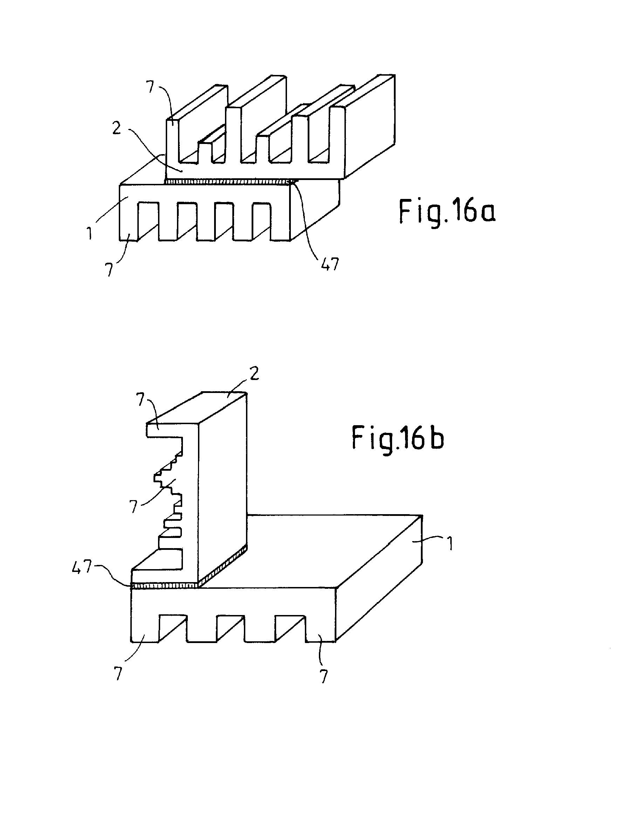

In den Figuren 16 a und 16 b ist ein Trägerkörper 1 mit einem anderen Trägerkörper 2 verbunden. Die Verbindung kann unterschiedlichster Art sein und richtet sich nach den Anforderungen. Mit dem Bezugszeichen 47 sind die Verbindungsmaterialien gekennzeichnet. Die Kühlelemente 7 sind in den Figuren 16a, b Rippen unterschiedlichster Art.

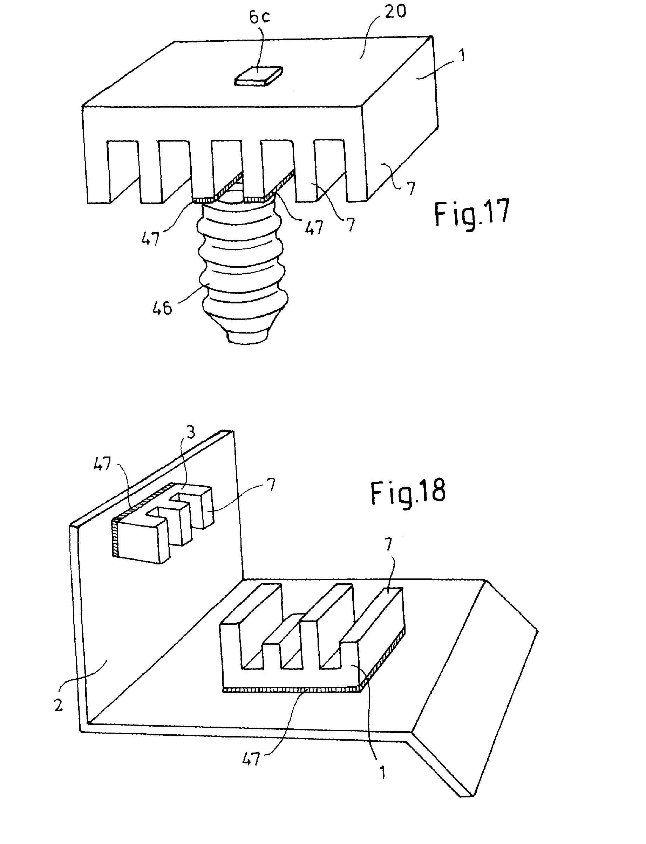

Figur 17 zeigt einen Trägerkörper 1 mit Kühlelementen 7, wobei auf die Kühlelemente 7 über Verbindungsmaterialien 47 ein Sockel E27 46 angeordnet ist. Dieser Sockel E27 46 dient zur Aufnahme eines Lichtmittels, z.B. einer Glühlampe. Der Sockel E27 46 dient hier auch allgemein für alle elektrischen Verbinder, Stecker oder Buchsen. Auf der Oberseite 20 ist eine LED 6 c angeordnet.
Figur 18 zeigt eine erfindungsgemäße Ausführungsform bei der ein Trägerkörper 1 mit einem anderen Trägerkörper 2 zu einem dreidimensionalen Aufbau (Array) verbunden ist. Mit 47 ist wieder das Verbindungsmaterial gekennzeichnet. Auf dem anderen Trägerkörper 2 ist ein weiterer Trägerkörper 3 angeordnet. Der Trägerkörper 2 ist als dreidimensionaler geometrischer Körper ausgebildet.

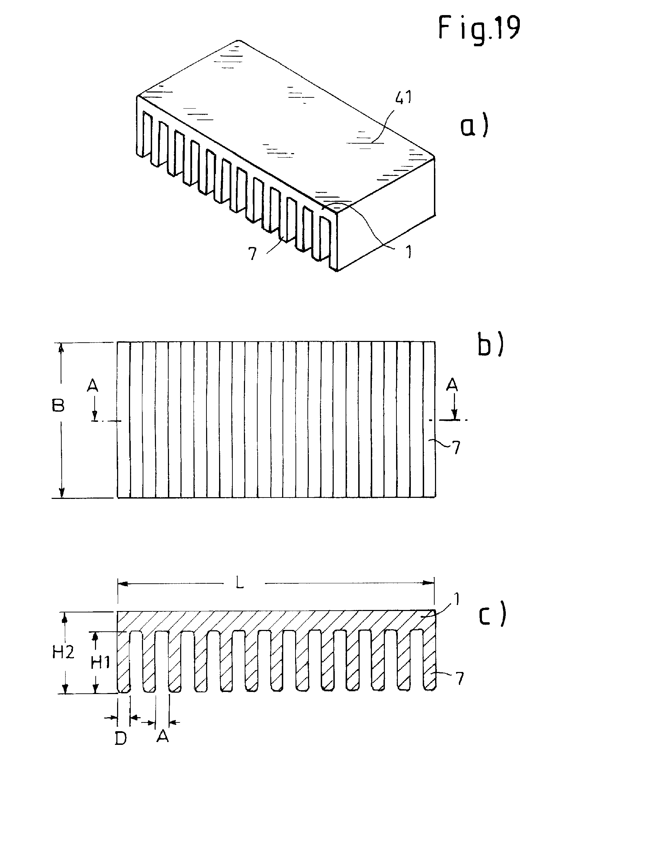

Die Figuren 19a, b, c zeigen einen Trägerkörper 1, der einstückig mit Kühlelementen 7 verbunden ist. Die gesamte Oberfläche des Trägerkörpers 1 ist als ein versinterter Metallisierungsbereich 41 ausgebildet. Der Metallisierungsbereich 41 besteht aus Wolfram und ist chemisch vernickelt. Figur 19 a zeigt den Trägerkörper 1 mit den Kühlelementen 7 in dreidimensionaler Ansicht und Figur 19b zeigt eine Aufsicht von unten auf die Kühlelemente 7. Figur 19 c zeigt einen Querschnitt nach der Linie A-A von Figur 19b.

Der Trägerkörper 1 mit den Kühlelementen 7 weist eine Länge L von 50 mm und eine Breite B von 25 mm auf. Die Höhe H1 der Kühlelemente 7 beträgt 10 mm und die Höhe H2 des gesamten Trägerkörpers 1 mit den Kühlelementen 7 beträgt 13 mm. Die einzelnen Kühlelemente 7 weisen eine Dicke D von 2 mm und der Abstand A der Kühlelemente 7 voneinander beträgt 2 mm. Die einzelnen Kühlelemente 7 sind an ihren Enden leicht abgerundet.

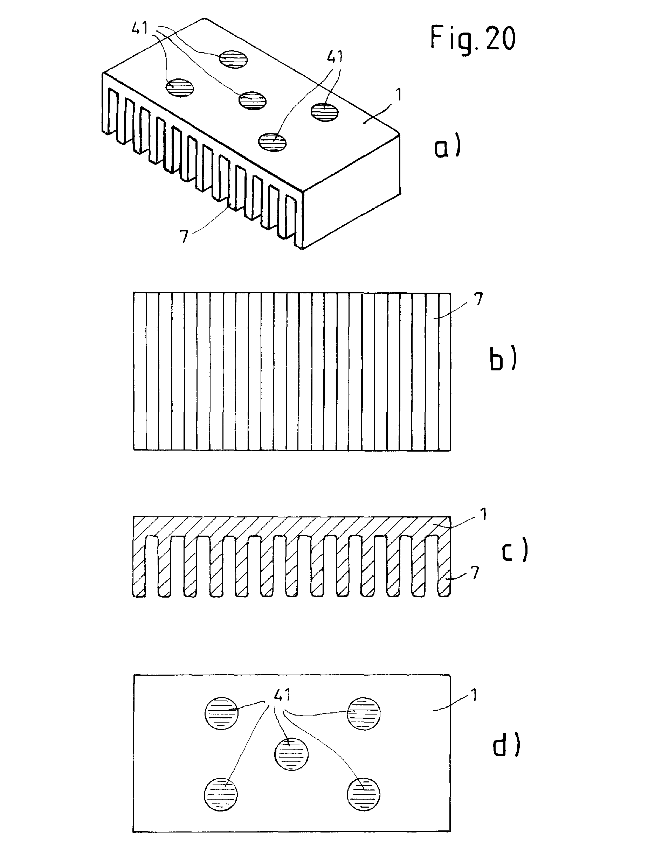

In den Figuren 20a, b, c, d ist ein Trägerkörper 1 mit Kühlelementen 7 gezeigt, der bezüglich seiner Maße mit dem Trägerkörper 1 von Figur 19 identisch ist. Hier ist jedoch nicht die gesamte Oberfläche des Trägerkörpers 1 als ein versinterter Metallisierungsbereich ausgebildet, sondern es sind nur einzelne kreisförmige Metallisierungsbereiche 41 angeordnet, die aus Wolfram bestehen und chemisch vernickelt sind. Die Wolframschicht weist eine Dicke von mindestens 6 um und die Nickelschicht eine Dicke von mindestens 2 um auf. Die einzelnen Metallisierungsbereiche 41 haben einen Durchmesser von 5 mm. Dieser Trägerkörper 1 dient zum Beispiel zur Aufnahme von LED's.

## Patentansprüche

1. Trägerkörper (1, 2) für elektrische oder elektronische Bauelemente (6a, 6b, 6c, 6d) oder Schaltungen, wobei der Trägerkörper (1, 2) elektrisch nicht oder nahezu nicht leitend ist und der Trägerkörper (1, 2) einstückig mit Wärme ab- oder zuführenden Kühlelementen (7) versehen ist, **dadurch gekennzeichnet, dass** der Trägerkörper (1, 2) eine Platine ist, der Trägerkörper (1, 2) und das Kühlelement (7) aus einer Keramik oder aus einem Kompositmaterial besteht und das Kompositmaterial elektrisch nicht oder nahezu nicht leitende Matrixmaterialien mit Wärme leitenden Zuschlagstoffen enthält und auf der Oberfläche des Trägerkörpers (1, 2) versinterte Metallisierungsbereiche (41) aufgebracht sind.

2. Trägerkörper nach Anspruch 1,
**dadurch gekennzeichnet, dass** mit dem Trägerkörper (1, 2) oder Kühlelement (7) mindestens eine Montagemöglichkeit (11) verbunden ist.

3. Trägerkörper nach Anspruch 1 oder 2,
**dadurch gekennzeichnet, dass** die Kühlelemente (7) beliebige Oberflächenstrukturierungen tragen oder aufweisen, die den Effekt der Oberflächenveränderung nach sich ziehen.

4. Trägerkörper nach einem der Ansprüche 1 bis 3,
**dadurch gekennzeichnet, dass** der Trägerkörper (1, 2) mit Metallschichten >5um verbunden ist, die beispielsweise über DCB Verfahren (Direct Copper Bonding) oder AMB Verfahren (Active Metall Brasing) aufgebracht sind.

5. Trägerkörper nach einem der Ansprüche 1 bis 4,
**dadurch gekennzeichnet, dass** aus der teilweisen oder gesamten Verformung des Trägerkörper (1, 2) sensorische Signale abgeleitet werden.

6. Trägerkörper nach einem der Ansprüche 1 bis 5,
**dadurch gekennzeichnet, dass** der Trägerkörper (1, 2) als Wärmequelle verwendet wird, in dem die entstehende Wärme über den Trägerkörper oder das Kühlelement (7) an das zu temperierende Medium abgegeben wird.

7. Trägerkörper nach einem der Ansprüche 1 bis 6,
**dadurch gekennzeichnet, dass** mit dem Trägerkörper eine oder mehrere Licht emittierende Stoffe oder eine oder mehrere Licht emittierende Komponenten sowie Kombinationen hiervon verbunden sind.

8. Trägerkörper nach einem der Ansprüche 1 bis 7,
**dadurch gekennzeichnet, dass** der Trägerkörper (1, 2) mit mindestens einem weiteren geometrisch gleichen oder ungleichen Trägerkörper (1, 2) über geeignete Verbindungsmaterialien zu einer Art dreidimensionalem Array verbunden ist.

9. Trägerkörper nach einem der Ansprüche 1 bis 8,
**dadurch gekennzeichnet, dass** der Trägerkörper (1, 2) mit einem oder mehreren Licht emittierenden Stoffen oder einer oder mehrerer Licht emittierender Komponenten sowie Kombinationen hiervon verbunden ist und gleichzeitig mit genormten oder ungenormten elektrischen Verbindern versehen ist.

10. Trägerkörper nach Anspruch 9,
**dadurch gekennzeichnet, dass** die elektrischen Verbinder Lampensockel wie E27, E14, GU-Serie, G-Serie, U-Serie, R-Serie sind.

11. Trägerkörper nach einem der Ansprüche 1 bis 10,
**dadurch gekennzeichnet, dass** mindestens ein und/oder unterschiedliche oder gleiche Trägerkörper (1, 2) beliebig oder gleichsinnig orientiert in ein Matrixmaterial eingebettet sind.

12. Trägerkörper nach einem der Ansprüche 1 bis 11,
**dadurch gekennzeichnet, dass** bei einem Trägerkörper (1, 2) durch Modifikation der Größe oder der Einfärbung oder der metallisierten Bereiche oder der Geometrie oder Veränderung der Kühlelemente (7) oder Anzahl der Kühlelemente (7) oder Kombinationen von diesen eine Veränderung des Wärmetransportes erreicht ist.

13. Trägerkörper nach einem der Ansprüche 1 bis 12,
**dadurch gekennzeichnet, dass** der Trägerkörper (1, 2) keine oder eine geringe Abschirmwirkung gegenüber elektrischen oder magnetischen oder elektromagnetischen Feldern oder Kombinationen von diesen aufweist und somit diese Felder den Trägerkörper (1, 2) auch durchdringen können.
